# FASCICULE DE BREVET EUROPEEN

(11) **EP 1 063 534 B1**
(45) Date de publication et mention de la délivrance du brevet: **02.07.2008**
(21) Numéro de dépôt: 00401740.6
(22) Date de dépôt: 19.06.2000
(51) Int. Cl.: G01R 33/383, G01R 33/38

(54) **Dispositif de mesure RMN portable**
Tragbares Kernspinresonanzmessgerät
Portable NMR measuring device

(30) Priorité: 23.06.1999 FR 9908022
(43) Date de publication de la demande: 27.12.2000
(73) Titulaire: COMMISSARIAT A L'ENERGIE ATOMIQUE, 75015 Paris (FR)
(72) Inventeur: Locatelli, Marcel, 38330 Montbonnot (FR); Cattin, Viviane, 38000 Grenoble (FR); Jeandey, Christian, 38120 Saint-Egreve (FR)
(74) Mandataire: Poulin, Gérard

(56) Documents cités:
- WO-A-99/00803
- GB-A- 2 137 757
- US-A- 4 714 881
- US-A- 5 900 793

## Description

### Domaine technique

La présente invention concerne un dispositif permettant de caractériser un objet ou un produit renfermant des composants contenant des protons identifiables à partir du phénomène de résonance magnétique nucléaire ou RMN.

### Etat de la technique antérieure

Des dispositifs de mesure RMN ont été développés pour des utilisations relatives à différents domaines techniques. Dans le domaine pétrolier, on peut citer les outils de puits divulgués par les brevets américains 3 483 465, 3 667 035, 4 480 227, 4 629 986, 4 710 713, 5 486 761, 5 488 342, 5 610 522 et 5 646 528. On peut citer aussi les outils pour carottes divulgués par les brevets américains 4 480 227, 4 564 811 et 4 885 540. Dans le domaine agro-alimentaire, on peut citer les brevets américains 3 966 973, 4 701 705 et 5 594 340. Dans le domaine du béton, on peut citer le brevet américain 5 672 968.

Dans les dispositifs RMN dits ouverts le produit ou l'objet à caractériser se trouve à l'extérieur du volume du dispositif. Dans ce cas en particulier, les paramètres critiques des dispositifs RMN sont la puissance d'émission RF et le niveau de l'induction de polarisation produite par un système magnéto-statique : électro-aimant en général ou aimants permanents dans le cas de systèmes mobiles.

Pour optimiser l'efficacité des aimants permanents, les dispositifs RMN ouverts de l'art antérieur utilisent des structures (pièces polaires, carcasses) en matériau magnétique doux. On peut se référer à ce sujet aux brevets américains 5 610 522 et 5 672 968. La présence de ces structures se traduit par un accroissement du poids du dispositif.

En outre, afin de limiter les perturbations externes, ils font appel (voir le brevet américain 5 672 968) à des écrans RF qui augmentent encore le poids du dispositif.

La revendication 1 a été délimité vis à vis du document US-A-5 900 793.

### Exposé de l'invention

L'invention se rapporte à un dispositif RMN ouvert, présentant une résolution spatiale de quelques cm³, un poids minimal et une puissance d'alimentation minimale afin de le rendre aisément manoeuvrable, autonome et d'un prix de revient minimal. Rendre un dispositif RMN portable implique des contraintes sur le poids des pièces polaires et des écrans. Il faut alors maximiser l'efficacité de la structure.

Pour parvenir à ce résultat, il est proposé d'associer des aimants permanents possédant une direction d'aimantation optimisée afin d'obtenir la plus grande densité d'énergie magnétique dans un volume déterminé correspondant à la résolution spatiale souhaitée du système de mesure.

Les écrans RF sont éliminés, l'antenne de mesure se trouvant protégée grâce à un phénomène d'auto-blindage.

L'invention a donc pour objet un dispositif de détection par RMN de protons résonnants contenus dans un objet, le dispositif comportant des moyens à aimants permanents de production d'un champ magnétique statique et homogène dans une région située à l'extérieur du dispositif et par rapport à laquelle sera positionné l'objet, le dispositif comportant également des moyens permettant l'émission d'un signal électromagnétique vers ladite région et la réception d'un signal électromagnétique renvoyé par ladite région en réponse audit signal émis, caractérisé en ce que :
- lesdits moyens à aimants permanents comprennent des aimants permanents disposés autour d'un axe sur lequel est située ladite région, de façon que leur direction d'aimantation soit dirigée vers ladite région et de façon que les valeurs d'aimantation desdits aimants permanents conjuguent leurs effets pour produire ledit champ magnétique statique et homogène dans ladite région,
- les moyens permettant l'émission et la réception desdits signaux électromagnétiques sont situés à l'intérieur de l'espace délimité par lesdits aimants permanents.

Avantageusement, l'axe autour duquel sont disposés lesdits aimants permanents constitue un axe de symétrie pour ces aimants permanents. Dans ce cas, les aimants permanents disposés autour de cet axe peuvent être disposés de manière adjacente pour former un tube. Ce tube peut alors posséder une section polygonale, c'est-à-dire que ses limites extérieure et intérieure ont une forme de polygone. Le dispositif peut comporter en outre des moyens de frettage en matériau amagnétique autour du tube. Il peut comporter en outre un capot en matériau conducteur électrique amagnétique pour enfermer le tube à l'exception de la face du tube située devant ladite région. Avantageusement, ce capot est fermé, du côté de la face du tube située devant ladite région, par une plaque en matériau diélectrique amagnétique.

La direction d'aimantation peut faire un angle de l'ordre de 45° par rapport audit axe.

Avantageusement, les aimants permanents sont choisis parmi les aimants permanents à base de terres rares, de ferrite et d'alnico. Ils sont par exemple en un matériau choisi parmi NdFeB et SmCo.

Les moyens permettant l'émission et la réception des signaux électromagnétiques peuvent être constitués par un solénoïde dont les spires délimitent approximativement une demi-sphère ouverte vers ladite région.

### Brève description des dessins

L'invention sera mieux comprise et d'autres avantages et particularités apparaîtront à la lecture de la description qui va suivre, donnée à titre d'exemple non limitatif, accompagnée des dessins annexés parmi lesquels :
- la figure 1 est une vue, selon la coupe I-I de la figure 2, d'un dispositif de mesure RMN portable selon la présente invention,
- la figure 2 est une vue de côté, en coupe, du dispositif représenté à la figure 1.

### Description détaillée d'un mode de réalisation de l'invention

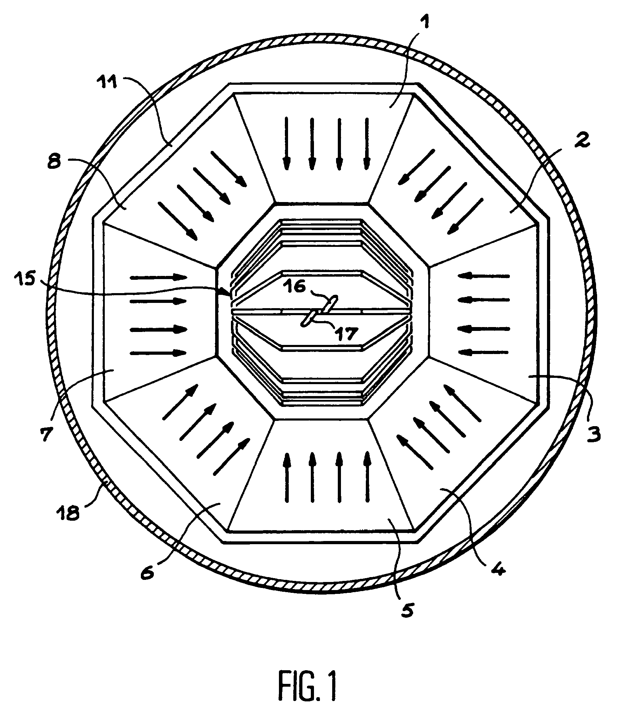

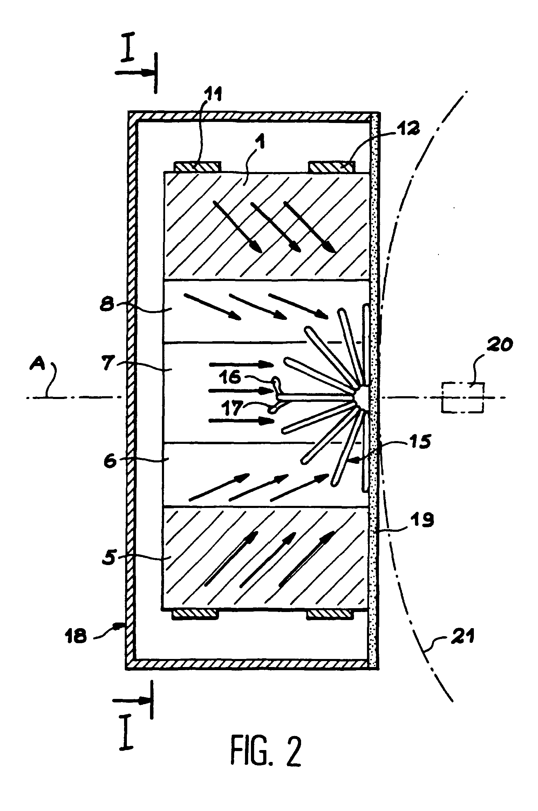

Dans le mode de réalisation représenté aux figures 1 et 2, le dispositif met en oeuvre huit aimants permanents référencés 1 à 8. Ces huit aimants permanents sont de taille identique. La section visible sur la figure 1 est trapézoïdale. A titre d'exemple, la grande base mesure 65 mm et la hauteur du trapèze fait 41,6 mm. La section visible sur la figure 2, pour les aimants 1 et 5, est rectangulaire. A titre d'exemple, la longueur mesure 47,5 mm.

Les aimants permanents 1 à 8 sont associés, comme représenté sur la figure 1, pour constituer un tube de section octogonale. Ils sont donc disposés de manière adjacente. L'angle au sommet des trapèzes fait donc 45°.

Les aimants 1 à 8 peuvent être des aimants aux terres rares, en particulier en NdFeB pour les applications à des températures comprises entre -10°C et 180°C. Pour des températures supérieures, on utilisera des aimants en SmCo.

La direction de magnétisation de ces aimants est de l'ordre de 45° par rapport à l'axe principal A de la structure. Cette direction de magnétisation est représentée par des flèches sur les figures 1 et 2.

La tenue mécanique de l'ensemble des aimants est assurée par des frettes 11 et 12 en matériau amagnétique et présentant une faible conductivité électrique. Elles peuvent être en acier inoxydable.

Le volume d'intérêt 20, dans lequel le champ magnétique statique induit est homogène, se situe sur l'axe principal A. Il présente une forme générale cylindrique pour ce mode de réalisation. Pour des aimants dont les dimensions et les matériaux ont été données ci-dessus, l'induction obtenue est de l'ordre de 0,17 T. Le volume d'intérêt 20 correspond à un cylindre de 15 mm de diamètre et de 12 mm de long, soit 2 cm³, dont le centre se situe à 25 mm de la sortie du système magnétique. Pour des aimants en NdFeB, le poids du système est de l'ordre de 5,4 kg.

L'émission de signaux électromagnétiques vers l'objet 21 à étudier et la réception du signal de réponse sont effectuées par l'antenne 15 qui est constituée d'un solénoïde dont les spires délimitent approximativement une demi-sphère placée à l'intérieur du système d'aimants et ouverte vers le volume d'intérêt 20. Les extrémités électriques 16, 17 de l'antenne se trouvent sensiblement au centre de la structure d'aimants. Cette configuration permet d'insérer l'antenne 15 dans la structure magnétique, procurant ainsi un auto-blindage par rapport à l'environnement extérieur.

La structure tubulaire que représente les aimants permanents joue le rôle d'écran électromagnétique de l'antenne du fait de la conductivité non nulle des aimants en terres rares. Cet effet est complété par le capot de protection 18 en matériau conducteur électrique amagnétique, par exemple en acier inoxydable ou en laiton. La face d'appui du capot est constituée par une plaque 19 en matériau diélectrique amagnétique, par exemple en plastique avec un revêtement céramique anti-usure.

## Revendications

1. Dispositif de détection par RMN de protons résonnants contenus dans un objet, le dispositif comportant des moyens à aimants permanents (1 à 8) de production d'un champ magnétique statique et homogène dans une région (20) située à l'extérieur du dispositif et par rapport à laquelle sera positionné l'objet (21), le dispositif comportant également des moyens (15) permettant l'émission d'un signal électromagnétique vers ladite région (20) et la réception d'un signal électromagnétique renvoyé par ladite région en réponse audit signal émis, **caractérisé en ce que** :
- lesdits moyens à aimants permanents comprennent des aimants permanents (1 à 8) disposés autour d'un axe (A) sur lequel est située ladite région (20), de façon que leur direction d'aimantation soit dirigée vers ladite région et de façon que les valeurs d'aimantation desdits aimants permanents (1 à 8) conjuguent leurs effets pour produire ledit champ magnétique statique et homogène dans ladite région (20),
- les moyens (15) permettant l'émission et la réception desdits signaux électromagnétiques sont situés à l'intérieur de l'espace délimité par lesdits aimants permanents (1 à 8).

2. Dispositif selon la revendication 1, **caractérisé en ce que** l'axe (A) autour duquel sont disposés lesdits aimants permanents (1 à 8) constitue un axe de symétrie pour ces aimants permanents.

3. Dispositif selon la revendication 2, **caractérisé en ce que** lesdits aimants permanents (1 à 8) disposés autour dudit axe (A) sont disposés de manière adjacente pour former un tube.

4. Dispositif selon la revendication 3, **caractérisé en ce que** ledit tube possède une section polygonale.

5. Dispositif selon l'une des revendications 3 ou 4, **caractérisé en ce qu'**il comporte en outre des moyens de frettage (11, 12) en matériau amagnétique autour dudit tube.

6. Dispositif selon l'une quelconque des revendications 3 à 5, **caractérisé en ce qu'**il comporte en outre un capot (18) en matériau conducteur électrique amagnétique pour enfermer le tube à l'exception de la face du tube située devant ladite région (20).

7. Dispositif selon la revendication 6, **caractérisé en ce que** le capot (18) est fermé, du côté de la face du tube située devant ladite région (20), par une plaque (19) en matériau diélectrique amagnétique.

8. Dispositif selon l'une quelconque des revendications 1 à 7, **caractérisé en ce que** ladite direction d'aimantation fait un angle de l'ordre de 45° par rapport audit axe (A).

9. Dispositif selon l'une quelconque des revendications 1 à 8, **caractérisé en ce que** lesdits aimants permanents (1 à 8) sont choisis parmi les aimants permanents à base de terres rares, de ferrite et d'alnico.

10. Dispositif selon la revendication 9, **caractérisé en ce que** lesdits aimants permanents (1 à 8) sont en un matériau choisi parmi NdFeB et SmCo.

11. Dispositif selon l'une quelconque des revendications 3 à 10, **caractérisé en ce que** lesdits moyens (15) permettant l'émission et la réception des signaux électromagnétiques sont constitués par un solénoïde dont les spires délimitent approximativement une demi-sphère ouverte vers ladite région (20).

## Claims

1. NMR device for detection of resonant protons contained in an object, the device comprising means with permanent magnets (1-8) for producing a static and uniform magnetic field in a region (20) located outside the device with respect to which the object (21) will be positioned, the device also comprising means (15) of emitting an electromagnetic signal to the said region (20) and reception of an electromagnetic signal returned from the said region in response to the said emitted signal, **characterized in that**:
- the said means with permanent magnets (1-8) comprise permanent magnets located around an axis (A) on which the said region (20) is located, such that their magnetization direction is directed towards the said region and such that the magnetization values of the said permanent magnets (1-8) combine their effects to produce the said static and uniform magnetic field in the said region (20),
- the means (15) for emission and reception of the said electromagnetic signals are located inside the space delimited by the said permanent magnets (1-8).

2. Device according to claim 1, **characterized in that** the axis (A) about which the said permanent magnets (1-8) are laid out forms an axis of symmetry for these permanent magnets.

3. Device according to claim 2, **characterized in that** the said permanent magnets (1-8) placed around the said axis (A) are placed adjacent to each other to form a tube.

4. Device according to claim 3, **characterized in that** the cross-section of the said tube is polygonal.

5. Device according to claim 3 or 4, **characterized in that** it also comprises hoop reinforcement means (11, 12) made of a non-magnetic material around the said tube.

6. Device according to any one of the claims 3 to 5, **characterized in that** it also comprises a cover (18) made of a non-magnetic electrical conducting material to enclose the tube except for the face of the tube located in front of the said region (20).

7. Device according to claim 6, **characterized in that** the cover (18) is closed on the side of the face of the tube located in front of the said region (20) by a plate (19) made of a non-magnetic dielectric material.

8. Device according to any one of the claims 1 to 7, **characterized in that** the said magnetization direction forms an angle of the order of 45° with respect to the said axis (A).

9. Device according to any one of the claims 1 to 8, **characterized in that** the said permanent magnets (1-8) are chosen among permanent magnets based on rare earths, ferrite and alnico.

10. Device according to claim 9, **characterized in that** the said permanent magnets (1-8) are made of a material chosen among NdFeB and SmCo.

11. Device according to any ane of the claims 3 to 10, **characterized in that** the said means (15) for emission and reception of electromagnetic signals are composed of a solenoid coil, in which the turns approximately delimit a hemisphere open towards the said region (20).

## Patentansprüche

1. Kernspinresonanzmessgerät zur Detektion von in einem Objekt schwingenden Protonen, wobei die Vorrichtung permanentmagnetische Einrichtungen (1 bis 8) zur Erzeugung eines statischen und homogenen Magnetfelds in einem Bereich (20) umfasst, der sich außerhalb der Vorrichtung befindet und im verhältnis zu dem das Objekt (21) positioniert wird, und die Vorrichtung auch Einrichtungen (15) umfasst, welche die Aussendung eines elektromagnetischen Signals in Richtung Bereich (20) und den Empfang eines durch den genannten Bereich zurückgesendeten elektromagnetischen Signals ermöglichen, als Antwort auf das gesendete Signal
**dadurch gekennzeichnet:**
- **dass** die permanentmagnetischen Einrichtungen Permanentmagnete (1 bis 8) umfassen, angeordnet um eine Achse (A) herum, auf der sich der genannte Bereich (20) befindet, so dass ihre Magnetisierungsrichtung auf den genannten Bereich ausgerichtet ist und dass die Magnetisierungswerte der genannten Permanentmagnete (1 bis 8) ihre Wirkungen vereinigen, um in dem genannten Bereich (20) das genannte statische und homogene Feld zu erzeugen, und
- die das Senden und Empfangen der genannten elektromagnetischen Signale ermöglichenden Einrichtungen (15) sich im Innern des durch die genannten Permanentmagnete (1 bis 8) abgegrenzten Raums befinden.

2. Gerät nach Anspruch 1, **dadurch gekennzeichnet, dass** die Achse (A), um die herum die genannten Permanentmagnete (1 bis 8) angeordnet sind, eine Symmetrieachse dieser Permanentmagnete ist.

3. Gerät nach Anspruch 2, **dadurch gekennzeichnet, dass** die um die Achse (A) herum angeordneten Permanentmagnete (1 bis 8) so aneinandergrenzen, dass sie ein Rohr bilden.

4. Gerät nach Anspruch 3, **dadurch gekennzeichnet, dass** das genannte Rohr einen polygonalen Querschnitt besitzt.

5. Gerät nach einem der Ansprüche 3 oder 4, **dadurch gekennzeichnet, dass** es außerdem Bandagierungseinrichtungen (11, 12) aus nichtmagnetischem Material um das genannte Rohr herum umfasst.

6. Gerät nach einem der Ansprüche 3 bis 5, **dadurch gekennzeichnet, dass** es außerdem eine Abdeckhaube (18) aus nichtmagnetischem elektrisch leitfähigem Material umfasst, um das Rohr zu umschließen, mit Ausnahme der Seite des Rohrs, die sich vor dem genannten Bereich (20) befindet.

7. Gerät nach Anspruch 6, **dadurch gekennzeichnet, dass** die Abdeckhaube (18) auf der vor dem Bereich (20) angeordneten Seite des Rohrs durch eine Platte (19) aus unmagnetischem dielektrischen Material verschlossen ist.

8. Gerät nach einem der Ansprüche 1 bis 7, **dadurch gekennzeichnet, dass** die genannte Magnetisierungsrichtung mit der genannten Achse (A) einen Winkel in der Größenordnung von 45° bildet.

9. Gerät nach einem der Ansprüche 1 bis 8, **dadurch gekennzeichnet, dass** die genannten Permanentmagnete (1 bis 8) ausgewählt werden unter den Permanentmagneten auf der Basis von Seltenen Erden, Ferrit und Alnico.

10. Gerät nach Anspruch 9, **dadurch gekennzeichnet, dass** die genannten Permanentmagnete (1 bis 8) aus einem zwischen NdFeB und SmCo ausgewählten Material sind.

11. Gerät nach einem der Ansprüche 1 bis 10, **dadurch gekennzeichnet, dass** die genannten Einrichtungen (15) zum Senden und Empfangen der elektromagnetischen Signale durch eine Zylinderspule gebildet werden, deren Windungen annähernd eine in Richtung Bereich (20) offene Halbkugel bilden.
